# EUROPEAN PATENT APPLICATION

(11) **EP 4 745 778 A1**
(43) Date of publication of application: **20.05.2026**
(21) Application number: 25215532.0
(22) Date of filing: 13.11.2025
(51) Int. Cl.: G06F 9/54, G06F 11/07

(54) **FUNCTIONAL EVENT MANAGEMENT SYSTEM AND METHOD**

(30) Priority: 18.11.2024 IN 202441089032
(71) Applicant: NXP B.V., 5656 AG Eindhoven (NL)
(72) Inventor: SRIVASTAVA, Neha, 5656 AG Eindhoven (NL); KUMAR, Nishant, 5656 AG Eindhoven (NL)
(74) Representative: Hardingham, Christopher Mark

(57) **Abstract**

A system that includes a request regulator and functional circuits is disclosed. The functional circuits generate multiple requests to execute control operations associated with the functional circuits. The request regulator receives the requests and context information associated with each functional circuit. The request regulator further grades each request based on the associated context information. Upon grading, the request regulator selects a predefined graded request to receive a control signal. The request regulator further generates a response based on the control signal and the context information of the predefined graded request. The response is provided to one or more functional circuits that generate the predefined graded request thereby initiating the control operations.

## Description

### FIELD OF USE

The present disclosure relates generally to electronic systems, and, more particularly, to functional event management system and method.

### BACKGROUND

Modern System-on-Chips (SoCs) include functional circuits (e.g., clock circuitry, digital signal processors, input/output interfaces, or the like) that perform various operations within the SoC. When an abnormal operation or a malfunction occurs within the functional circuits, the functional circuits generate events (e.g., a functional reset event, a destructive reset event, or a fault control event) in response to the malfunction, to initiate recovery and maintain operational integrity of the functional circuits. Based on a priority of the event, a control action associated with the event is executed to address and contain the impact of the malfunction. However, simultaneous occurrence of the events from the functional circuits lead to cross-talk within the SoC, inadvertently escalating a low priority event and potentially impacting a reliability of the SoC.

### BRIEF DESCRIPTION OF THE DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a schematic diagram of a system, in accordance with an embodiment of the present disclosure;
FIG. 2 illustrates a schematic diagram of a request regulator and a plurality of functional circuits of the system of FIG. 1, in accordance with an embodiment of the present disclosure; and
FIGS. 3A-3B collectively, represent a flowchart that illustrates a method executed by the system of FIG. 1, in accordance with an embodiment of the present disclosure.

### DETAILED DESCRIPTION

The detailed description of the appended drawings is intended as a description of the embodiments of the present disclosure and is not intended to represent the only form in which the present disclosure may be practiced. It is to be understood that the same or equivalent functions may be accomplished by different embodiments that are intended to be encompassed within the scope of the present disclosure.

### Overview:

In conventional System-on-Chips (SoCs), functional circuits (e.g., math accelerators and digital signal processors) generate requests when an abnormal operation or a malfunction occurs in the functional circuits. The requests are generated to perform a variety of control operations of varying grades simultaneously in response to the malfunction. Based on the processing of the requests by controllers of the SoC, simultaneous control operations are initiated for the functional circuits. Further, upon executing the control operations, the functional circuits are maintained in a secure state thereby allowing a recovery of the functional circuits.

Cross-talk between the functional circuits and the controllers occur due to various simultaneous interactions between the controllers and the functional circuits. Due to the cross-talk, erroneous requests are further generated by one or more functional circuits. When the erroneous requests are processed by the controllers, errata such as design escalations and processing of spurious requests occur in the SoC thereby impacting a reliability of the SoC and leading to a high recovery time of the SoC from such erroneous requests. The erroneous requests are typically masked by masking architectures, however, the masking architectures are complex to design and consume a large size of the SoC. In light of the aforementioned problems, an availability of the SoC to perform intended functions is affected and a user experience is degraded.

Various embodiments of the present disclosure disclose a system which includes functional circuits, a request regulator, and controllers. The functional circuits generate requests based on occurrence of one or more events. The request regulator receives the requests from the functional circuits. Further, the request regulator grades each request based on context information associated with one or more functional circuits such that at least one of the requests has a predefined grade such as a highest grade. The request regulator further provides the predefined graded request (e.g., the highest graded request) to one of the controllers. Upon receiving the highest graded request, the corresponding controller provides a control signal to the request regulator. Based on the received control signal and the context information associated with the highest graded request, the request regulator generates a response. The request regulator provides the response to at least one functional circuit such that a control operation associated with the functional circuit is initiated.

The request regulator offers a scalable solution to manage complex interactions between a large number of functional circuits and controllers. The request regulator of the present disclosure dynamically grades the requests generated by the functional circuits based on the context information associated with the functional circuits. The context information is configurable based on execution of at least one application by the processor and varies based on a virtualized environment where the at least one application is executed. For example, in SoCs where the functional circuits can be dynamically allocated for execution of different applications, context-aware grading by the request regulator allows the requests to be dynamically graded in alignment with a currently executed application. Thus, the request regulator is context-aware and virtualization aware.

The request regulator selectively provides one or more highest graded requests to the controllers thereby eliminating complications due to cross domain interactions (e.g., reset domain crossing, clock domain crossing, or the like). Additionally, the request regulator blocks all requests except the highest graded request to avoid generation of erroneous requests that may occur due to cross-talk between the functional circuits and the controllers. In the absence of the erroneous requests, the request regulator timely generates the response and the control operation is initiated to rectify errors or faults in the corresponding functional circuits. Thus, the present disclosure allows recovery of the functional circuits at the lowest granular recovery (e.g., recovery without escalations or generation of the erroneous requests).

As the functional circuits are timely recovered, the functional circuits become available to execute operations associated with a system-on-chip (SoC) comprising the system. Thus, an operational reliability of the SoC and a user experience is enhanced. Further, as the requests are processed without the need to implement complex masking architectures, the SoC of the present disclosure is simple to design and has a reduced size over conventional SoCs.

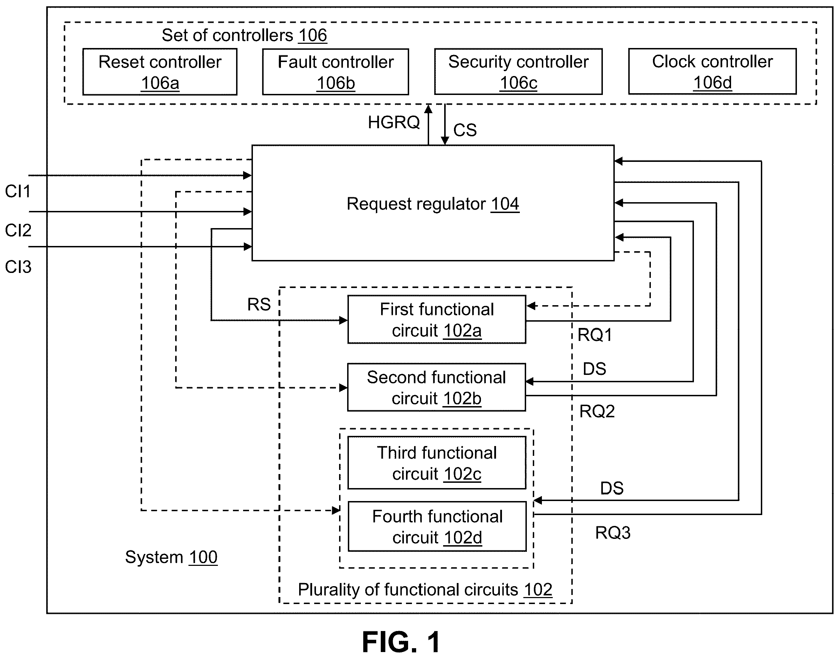

FIG. 1 illustrates a schematic block diagram of a system 100, in accordance with an embodiment of the present disclosure. The system 100 may be within a system-on-chip (SoC). Further, the system 100 may be configured to manage various functional events. For the sake of brevity of explaining the present disclosure, it is assumed that the system 100 may be within an autonomous vehicle. However, the scope is not limited to it. In various embodiments, the system 100 may be implemented in devices, machines, systems, or the like, that manage functional events. The system 100 may include a plurality of functional circuits 102, a request regulator 104, and a set of controllers 106.

The system 100 may be coupled to a set of sensors. Examples of the set of sensors may include a detection and ranging sensor, an ultrasonic sensor, a speed sensor, a tire pressure monitoring sensor, or the like. The set of sensors may sense a physical parameter. Examples of the physical parameter may include pressure, temperature, speed, distance, humidity, proximity, magnetic field, acceleration, or the like. Based on a variation in the sensed physical parameter, attributes associated with the set of sensors may vary. Examples of the attributes associated with the set of sensors may include capacitance, resistance, inductance, frequency, amplitude, orientation, phase shift, optical characteristics, current, voltage, or the like. The set of sensors may thus provide sensor data to the system 100 (*e.g.,* the plurality of functional circuits 102) based on the attributes.

### Plurality of functional circuits 102:

The plurality of functional circuits 102 may include suitable circuitry that may be configured to perform one or more operations. In an example, the plurality of functional circuits 102 may be configured to receive the sensor data from the set of sensors. Based on the received sensor data, the plurality of functional circuits 102 may be configured to execute functional operations that include at least one of a set of normal operations and a set of control operations. The set of normal operations may correspond to execution of tasks or processes to compute real-time functional signals. In an example, a normal operation of one of the plurality of functional circuits 102 may correspond to processing the sensor data such as acceleration data, to compute the functional signals. Further, the functional signals may be associated with automatically locking a door of the autonomous vehicle when the autonomous vehicle has attained a threshold speed in motion.

The set of control operations may correspond to a set of procedures and actions (e.g., a set of functional control events) executed by the plurality of functional circuits 102 in response to one or more events such as abnormal functional events, hereinafter referred to as "abnormal events", occurring in the plurality of functional circuits 102. Examples of the abnormal events may include faults, system attacks, or operational errors in the plurality of functional circuits 102. Further, the set of control operations may correspond to a reset operation or a reset control event, a fault control operation or a fault control event, a security operation or a security control event, a synchronization operation or a synchronization event, or the like.

The reset operation may be initiated to restore the plurality of functional circuits 102 to a predefined state thereby ensuring accurate initialization and reliable operation of the plurality of functional circuits 102. Examples of the reset operation may include, but not be limited to, resetting state machines, clearing registers, and initializing memories within the plurality of functional circuits 102. In a scenario, one of the plurality of functional circuits 102 may deviate from the normal operation of the plurality of functional circuits 102. Thus, the reset operation may be executed to restore the functional circuit to a default operating mode.

The fault control operation may be initiated to launch corrective actions to restore the normal operation of the plurality of functional circuits 102. The corrective actions may correspond to error logging, fault isolation, reconfiguration of the plurality of functional circuits 102, or the like. Examples of the fault control operation may correspond to fault detection and correction operations to ensure reliability, minimize downtime, and enhance fault tolerance of the plurality of functional circuits 102. In a scenario, due to a fault in one of the plurality of functional circuits 102, the functional circuit may be unable to process the acceleration data. Thus, the fault control operation may be executed to rectify the fault in the functional circuit.

The security operation may be initiated to secure the plurality of functional circuits 102 from unauthorized access, data breaches, or malicious attacks. Examples of the security operation may include user authentication, encryption of sensitive data, access regulation, or the like. In a scenario, a malicious attack on one of the plurality of functional circuits 102 may result in leakage of sensitive information from one of the plurality of functional circuits 102. Thus, the security operation may be executed to erase the malicious file in the functional circuit.

The synchronization operation may be initiated to synchronize or coordinate the plurality of functional circuits 102. Examples of the synchronization operation may include clock synchronization, clock alignment, state consistency checks, or the like. In a scenario, the functional signal generated by one of the plurality of functional circuits 102 may be out-of-sync with a clock signal of the SoC. Thus, the synchronization operation may be executed to sync the clock signal and the functional signal. The set of control operations is explained in further detail with reference to the set of controllers 106.

When one or more events (e.g., the abnormal events) occur in the plurality of functional circuits 102, each functional circuit is further configured to detect the one or more events in the corresponding functional circuit. In one scenario, an abnormal event may occur in a functional circuit while executing the set of normal operations, e.g., the reception of the sensor data from the set of sensors by the functional circuit. Thus, the functional circuit may detect the occurrence of the abnormal event. In further scenarios, the same or another abnormal event may occur when the plurality of functional circuits 102 may be idle. Upon detecting the abnormal event, the corresponding functional circuit may generate a request to initiate corrective actions associated with the functional circuit. For the sake of brevity of explaining the ongoing description, it is assumed that the abnormal event occurs in each of the plurality of functional circuits 102. Thus, the plurality of functional circuits 102 may be configured to generate a plurality of requests RQ1-RQ3 (e.g., a first request denoted by "RQ 1" in FIG. 1, a second request denoted by "RQ2" in FIG. 1, and a third request denoted by "RQ3" in FIG. 1) based on the occurrence of the one or more events. Each of the plurality of requests RQ1-RQ3 may include an identifier of the corresponding functional circuit of the plurality of functional circuits 102 and a type of the abnormal event such as an attack, a fault, or an operational error in the corresponding functional circuit. The plurality of functional circuits 102 may correspond to a digital signal processor (DSP), a math accelerator, a filtering circuit, a calibration circuit, a control and actuation circuit, an audio processing circuit, or the like.

The plurality of functional circuits 102 may include a first functional circuit 102a, a second functional circuit 102b, a third functional circuit 102c, and a fourth functional circuit 102d. In an embodiment, a functional circuit of the plurality of functional circuits 102 may be configured to generate a request of the plurality of requests RQ1-RQ3. For example, the first functional circuit 102a may be configured to generate the first request RQ1. Further, the second functional circuit 102b may be configured to generate the second request RQ2. In addition, at least two or more functional circuits of the plurality of functional circuits 102 may be grouped and the grouped at least two or more functional circuits may be configured to generate another request of the plurality of requests RQ1-RQ3. For example, if the third functional circuit 102c and the fourth functional circuit 102d are grouped, instead of generating individual requests, the third functional circuit 102c and the fourth functional circuit 102d may be configured to generate the third request RQ3. The plurality of functional circuits 102 may be further configured to provide the plurality of requests RQ1-RQ3 to the request regulator 104. At least one request of the plurality of requests RQ1-RQ3 may be utilized to initiate at least one of the set of control operations.

The plurality of functional circuits 102 may be further coupled to a processor of the SoC. The processor may execute a plurality of applications, for example, continuously or at predefined time intervals. The plurality of applications may be associated with the plurality of functional circuits 102. For example, the plurality of functional circuits 102 may be dynamically allocated for execution of the plurality of applications. For example, based on the execution of a first set of applications of the plurality of applications, one or more first functional circuits of the plurality of functional circuits 102 allocated for the execution of the first set of applications may be assigned a high priority as compared to remaining functional circuits of the plurality of functional circuits 102. Likewise, based on the execution of a second set of applications of the plurality of applications, one or more second functional circuits of the plurality of functional circuits 102 may be assigned a high priority over the remaining functional circuits. Examples of the plurality of applications may include a lane assist application, an audio processing application, a crash recovery application, or the like.

Based on the execution of each of the plurality of applications, the processor may generate a wakeup signal and provide the wakeup signal to the plurality of functional circuits 102. The plurality of functional circuits 102 may be configured to receive the wakeup signal from the processor. Upon receiving the wakeup signal, the plurality of functional circuits 102 may be further configured to transition from a low power mode to a normal mode.

Upon transitioning to the normal mode, two or more functional circuits of the plurality functional circuits 102 may be grouped based on at least one of similar functions or related functions. In an example, the third functional circuit 102c and the fourth functional circuit 102d may be associated with deployment of airbags and automatic unlocking of a door of the autonomous vehicle, respectively, in an event of a crash. Thus, when the crash recovery application is executed, the third functional circuit 102c and the fourth functional circuit 102d may be grouped and configured to generate a single request (e.g. the third request RQ3). Further, the third functional circuit 102c and the fourth functional circuit 102d may have a common group identifier (ID) based on the grouping. For the sake of ongoing discussion and without deviating from the scope of the disclosure, it is assumed that the third functional circuit 102c and the fourth functional circuit 102d are grouped. However, in various embodiments, different functional circuits may be grouped.

The processor may further generate context information based on the execution of each application of the plurality of applications upon transitioning to the normal mode. The context information may be associated with the plurality of functional circuits 102. The context information may indicate the application that is executed from the plurality of applications. Further, the context information of a functional circuit may include an ID of the functional circuit, dependency details of the functional circuit with respect to at least one of the remaining functional circuits of the plurality of functional circuits 102, error handling requirements associated with correction of errors or faults in the functional circuit, interference correction in the functional circuit, a security level of the functional circuit, and the like. Similarly, the context information of a functional circuit group including two or more functional circuits may include the group ID of the two or more functional circuits, dependency details of the two or more functional circuits with respect to at least one of the remaining functional circuits of the plurality of functional circuits 102, error handling requirements associated with correction of errors or faults in the two or more functional circuits, interference correction in the two or more functional circuits, a security level of the two or more functional circuits, and the like. Thus, the context information may indicate a priority level of each functional circuit or each functional circuit group in the plurality of functional circuits 102.

In a scenario, a first application of the plurality of applications may be linked to lane maintenance of the autonomous vehicle. The first application may be executed when the autonomous vehicle is in motion. Further, one of the plurality of functional circuits 102 such as the first functional circuit 102a may be associated with a lane assist system of the autonomous vehicle, and another functional circuit such as the second functional circuit 102b may be associated with an audio processing system of the autonomous vehicle. The first functional circuit 102a may be a control and actuation circuit and the second functional circuit 102b may be an audio processing circuit. Based on the execution of the first application, the processor may flag the control and actuation circuit with a higher priority than the audio processing circuit. Further, the processor may generate the context information associated with each of the control and actuation circuit and the audio processing circuit indicating the priorities. In an example, the dependency details in the context information associated with the control and actuation circuit may indicate a high dependency of the remaining functional circuits on the control and actuation circuit whereas the dependency details in the context information associated with the audio processing circuit may indicate a low dependency of the remaining functional circuits on the audio processing circuit. Thus, for the first application, the context information associated with the control and actuation circuit may indicate a high priority level of the control and actuation circuit and the context information associated with the audio processing circuit may indicate a low priority level of the audio processing circuit.

In further scenarios, a second application of the plurality of applications may be linked to audio processing. Further, the second application may be executed when the autonomous vehicle may be parked (e.g., stationary). Based on the execution of the second application, the processor may flag the audio processing circuit with a higher priority than the control and actuation circuit. Further, the processor may generate the context information associated with each of the control and actuation circuit and the audio processing circuit. In an example, the context information associated with the control and actuation circuit may indicate low error handling requirements whereas the context information associated with the audio processing circuit may indicate high error handling requirements. Thus, the context information associated with the control and actuation circuit may indicate a low priority level and the context information associated with the audio processing circuit may indicate a high priority level.

Continuing the above examples, based on the execution of different applications, priorities of the plurality of functional circuits 102 as indicated in the corresponding context information may also dynamically vary. For example, based on the execution of the first application, the context information generated for the control and actuation circuit may indicate the high priority level, whereas based on the execution of the second application, the context information generated for the control and actuation circuit may indicate the low priority level.

For the sake of brevity, the plurality of functional circuits 102 is shown to include the first functional circuit 102a, the second functional circuit 102b, the third functional circuit 102c, and the fourth functional circuit 102d. Additionally, the plurality of functional circuits 102 is shown to generate the first request RQ1, the second request RQ2, and the third request RQ3. However, in various embodiments, the plurality of functional circuits 102 may include additional functional circuits. For example, in a 5 nanometer (nm) architecture of the SoC, the plurality of functional circuits 102 may exceed 1000. In further embodiments, the plurality of functional circuits 102 may generate additional requests.

At least one or more functional circuits of the plurality of functional circuits 102 may be configured to receive a response, denoted by "RS" in FIG. 1 from the request regulator 104, further, remaining functional circuits of the plurality of functional circuits 102 may be configured to receive a disable signal, denoted by "DS" in FIG. 1, as explained in the ongoing description.

### Request regulator 104:

The request regulator 104 may be coupled to the processor, the plurality of functional circuits 102, and the set of controllers 106. The request regulator 104 may include suitable circuitry that may be configured to execute one or more operations. In an example, the request regulator 104 may be configured to receive the plurality of requests RQ1-RQ3 from the plurality of functional circuits 102. The request regulator 104 may be further configured to receive the context information associated with each of the plurality of functional circuits 102 from the processor. In an example, the context information associated with the first functional circuit 102a may be hereinafter referred to as "first context information CI1", the context information associated with the second functional circuit 102b may be hereinafter referred to as "second context information CI2", and the context information associated with both the third functional circuit 102c and the fourth functional circuit 102d may be hereinafter referred to as "third context information CI3". Thus, the request regulator 104 may receive the first context information CI1, the second context information CI2, and the third context information CI3.

The request regulator 104 may be further configured to grade each request of the plurality of requests RQ1-RQ3 based on the context information associated with each functional circuit of the plurality of functional circuits 102 such that a set of requests of the plurality of requests RQ1-RQ3 has a predefined grade. The set of requests having the predefined grade indicates that the set of requests has a highest grade. In an embodiment, at least one functional circuit of the plurality of functional circuits 102 may generate the set of requests. Based on the context information indicating a highest level of priority for the at least one functional circuit, the request regulator 104 may grade the set of requests with the highest grade. Further, the request regulator 104 may grade each request of the plurality of requests RQ1-RQ3 dynamically based on the execution of each application of a set of applications (e.g., the first applications or the second applications) of the plurality of applications. In other words, based on the execution of different applications, as the corresponding context information may dynamically vary, thus each request may be dynamically graded based on the corresponding context information.

The grading of the plurality of requests RQ1-RQ3 may correspond to assigning a level of criticality to each of the plurality of requests RQ1-RQ3 based on the execution of an application as indicated by the context information. The grades associated with the plurality of requests RQ1-RQ3 may correspond to one of a highest grade (e.g., a high level of criticality), a lowest grade (e.g., a low level of criticality), and an intermediate grade (e.g., an intermediate level of criticality). The intermediate grade may be lower than the highest grade, and higher than the lowest grade. For example, when the highest grade is represented by 1 and the lowest grade is represented by 10, the intermediate grade may be represented by a number in a range of 2-9.

In a scenario, during execution of the first application, the processor may provide the first context information CI1 associated with the first functional circuit 102a, the second context information CI2 associated with the second functional circuit 102b, and the third context information CI3 associated with the third functional circuit 102c and the fourth functional circuit 102d, to the request regulator 104. Further, the first context information CI1, the second context information CI2, and the third context information CI3 may indicate the highest dependency of remaining functional circuits on the first functional circuit 102a, a lowest dependency of remaining functional circuits on the second functional circuit 102b, and an intermediate dependency of remaining functional circuits on the third functional circuit 102c and the fourth functional circuit 102d, respectively. Thus, the request regulator 104 may determine a predefined grade (e.g., a highest grade) for the first request RQ1 (such as '1'). Accordingly, the request regulator 104 may determine grades for each of the second request RQ2 (such as '10') and the third request RQ3 (such as '7') such that the second request RQ2 and the third request RQ3 may be graded lower than the first request RQ1.

In further scenarios, during execution of the first application, the first context information CI1, the second context information CI2, and the third context information CI3 may indicate the intermediate dependency of remaining functional circuits on the first functional circuit 102a, a lowest dependency of remaining functional circuits on the second functional circuit 102b, and a highest dependency of remaining functional circuits on the third functional circuit 102c and the fourth functional circuit 102d, respectively. Thus, the request regulator 104 may determine a predefined grade (e.g., a highest grade) for the third request RQ3 (such as '1'). Accordingly, the request regulator 104 may determine grades for each of the second request RQ2 (such as '10') and the first request RQ1 (such as '7') such that the second request RQ2 and the first request RQ1 may be graded lower than the first request RQ1. Thus, based on the varying context information that may be generated upon the execution of the first application, the request regulator 104 may dynamically determine different grades for the first request RQ1.

In additional scenarios, a third application of the plurality of applications that may be linked to noise cancellation may be executed when the autonomous vehicle is in motion. During the execution of the third application, the processor may provide the first context information CI1, the second context information CI2, and the third context information CI3, to the request regulator 104. Further, the first context information CI1 and the second context information CI2, may indicate high interference, and the third context information CI3 may indicate low interference. Thus, the request regulator 104 may determine the predefined grade (e.g., the highest grade) for each of the first request RQ1 and the second request RQ2 (such as '1'). Accordingly, the request regulator 104 may determine the grade for the third request RQ3 (such as '10') such that the third request RQ3 may be graded lower than the first request RQ1 and the second request RQ2. Thus, based on the execution of the first application or the second application, the request regulator 104 may dynamically determine the grades for each of the first request RQ1, the second request RQ2, and the third request RQ3. For the sake of simplicity of the ongoing description and without deviating from the scope of the disclosure, it is assumed that the set of requests may include a single request.

Although it is mentioned that the grades associated with the plurality of requests RQ1-RQ3 may be within a range of 1-10, in various embodiments, the range associated with the grade may be configurable based on a use case of the SoC. For example, the range associated with the grade may vary based on resource allocation due to execution of the various applications operating at any instance. In other words, the range associated with the grade may be dynamic based on virtualization of the SoC such that distribution of components (e.g., the plurality of functional circuits 102) may impact prioritization and processing of requests.

The request regulator 104 may be further configured to block remaining requests from the plurality of requests RQ1-RQ3 that are different from the set of requests. The set of requests with the predefined grade (e.g., the highest grade) may be hereinafter referred to as a "highest graded request HGRQ". Thus, the predefined graded request may be the highest graded request HGRQ. Upon blocking the remaining requests, the request regulator 104 may be further configured to disable corresponding functional circuits of the plurality of functional circuits 102. The request regulator 104 may disable the corresponding functional circuits for the time period by generating the disable signal denoted by "DS" in FIG. 1. The time period may be determined by the processor. The time period may correspond to a time interval to execute one or more control operations (e.g., the set of control operations) associated with the set of requests. In an example, the first request RQ1 may be the highest graded request HGRQ. The request regulator 104 may thus block the second request RQ2 and the third request RQ3.

The disable signal DS may be provided to the second functional circuit 102b indicating the second functional circuit 102b to disable the further generation of the second request RQ2 for the time period, and the third functional circuit 102c and the fourth functional circuit 102d to disable the further generation of the third request RQ3 for the time period. In addition, the second functional circuit 102b and the grouped third and fourth functional circuits 102c and 102d are disabled from receiving any inputs such as sensor data for the time period thereby preventing the second functional circuit 102b and the grouped third and fourth functional circuits 102c and 102d from executing functional operations. Thus, for the time period, any modifications in sampling of the sensor data or latching of any of the second request RQ2 or the third request RQ3 may be prevented. Such isolation of the second functional circuit 102b and the grouped third and fourth functional circuits 102c and 102d for the time period may ensure absence of further reception of the second request RQ2 and the third request RQ3 by the request regulator 104 until the control operation associated with the set of requests is executed.

The request regulator 104 may be further configured to determine the control operation to be initiated based on the highest graded request HGRQ. In other words, the highest graded request HGRQ may indicate the type of the abnormal event. Thus, the request regulator 104 may detect the type of the abnormal event and determine the control operation to initiate corrective actions associated with the detected abnormal event. The request regulator 104 may be further configured to provide the highest graded request HGRQ to at least one controller of the set of controllers 106 based on the determined control operation. In an example, when the type of the abnormal event as indicated by the highest graded request HGRQ may be an operational error, the request regulator 104 may determine a reset operation to correct the operational error in the one or more functional circuits that are associated with the highest graded request HGRQ.

The request regulator 104 may further provide the highest graded request HGRQ to a corresponding controller of the set of controllers 106 such that the associated control operation (e.g., the reset operation) may be executed. Although it is mentioned that the request regulator 104 may block the remaining requests that may be different from the highest graded request HGRQ, in various embodiments, the request regulator 104 may include a control interface having status bits, which may be utilized to test the system 100 during one of development, diagnostic, and validation of the SoC. Based on a status of the control bits of the control interface, the request regulator 104 may be further configured to block any other request that may be required to test the system 100. In other words, based on the status of the control bits, the request regulator 104 may provide a selective request of the plurality of requests RQ1-RQ3 to one of the controllers of the set of controllers 106. Thus, the request regulator 104 (e.g., control bits of the request regulator 104) may be software configurable according to the specific testing or diagnostic requirements.

The request regulator 104 may be further configured to store diagnostics data associated with the highest graded request HGRQ based on initiation of the corresponding control operation. In an embodiment, the diagnostics data may correspond to context information associated with the highest graded request HGRQ, a grade associated with the highest graded request HGRQ, and the like. Additionally, the diagnostics data may further correspond to the blocked requests, the control operation executed based on the highest graded request HGRQ, or the like. In an embodiment, the diagnostics data may be used to debug the system 100.

In various embodiments, the request regulator 104 may be coupled to additional components of the SoC. Examples of the additional components may include at least one of a core, a memory controller, a network interface, a security module, input/output (I/O) interface, a debug interface, or the like.

### Set of controllers 106:

The set of controllers 106 may correspond to dedicated hardware modules within the SoC that may be designed to manage and coordinate specific functions (e.g., the control operation) of various components (e.g., the plurality of functional circuits 102). The set of controllers 106 may include a reset controller 106a, a fault controller 106b, a security controller 106c, and a clock controller 106d. The set of controllers 106 may be configured to receive the highest graded request HGRQ from the request regulator 104. Based on the highest graded request HGRQ (e.g., the set of requests), the set of controllers 106 may be further configured to generate a control signal denoted by "CS" in FIG. 1 to initiate the set of control operations.

In a scenario, the request regulator 104 may be configured to provide the highest graded request HGRQ (e.g., the first request RQ1) to the reset controller 106a when the type of the abnormal event may be an operational error in the first functional circuit 102a. The reset controller 106a may be further configured to generate the control signal CS. Based on the control signal CS generated by the reset controller 106a, a control operation such as a reset operation corresponding to the functional circuit associated with the highest graded request HGRQ may be executed. Thus, a controlled reset may be initiated to prevent malfunction of the first functional circuit 102a. The reset operation may be one of a functional reset, a destructive reset, a power-on-reset, or the like.

In some embodiments, the reset controller 106a may include one or more reset controllers that generate the control signal CS corresponding to each of the functional reset, the destructive reset, and the power-on-reset. Further, the one or more reset controllers may receive the highest graded request HGRQ based on the type of the abnormal event. Thus, the control signal CS may be at least one of a controlled functional reset, a controlled destructive reset, and a controlled power-on-reset.

In further scenarios, the request regulator 104 may be configured to provide the highest graded request HGRQ (e.g., the first request RQ1). The fault controller 106b may receive the first request RQ1 when the type of the abnormal event may be a fault in the first functional circuit 102a. The fault controller 106b may be further configured to generate the control signal CS. Based on the control signal CS generated by the fault controller 106b, a corrective action to correct or isolate faults in the first functional circuit 102a may be executed. The corrective action may correspond to a fault control operation (e.g., the control operation). Although it is mentioned that corrective action to correct or isolate faults in the first functional circuit 102a may be executed, in various embodiments, the fault controller 106b may be coupled to the reset controller 106a such that the control signal CS may further initiate a reset operation in the first functional circuit 102a.

In additional scenarios, the request regulator 104 may be configured to provide the highest graded request HGRQ to the security controller 106c (e.g., the first request RQ1). The security controller 106c may receive the first request RQ1 when the type of the abnormal event may be a malicious attack on the first functional circuit 102a. The security controller 106c may be further configured to generate the control signal CS. Based on the control signal CS generated by the security controller 106c, the control operation (e.g., a controlled security operation) corresponding to the first functional circuit 102a may be executed to prevent unauthorized access to the first functional circuit 102a. Although it is mentioned that the controlled security operation may be initiated to prevent unauthorized access to the first functional circuit 102a, in various embodiments, the security controller 106c may be coupled to the reset controller 106a such that the control signal CS may further initiate a reset operation in the first functional circuit 102.

In yet additional scenarios, the request regulator 104 may be configured to provide the highest graded request HGRQ to the clock controller 106d such that the clock controller 106d may be configured to receive the first request RQ1. The clock controller 106d may receive the first request RQ1 when the type of the abnormal event may be a timing or a synchronization error in the first functional circuit 102a. The clock controller 106d may be further configured to generate the control signal CS. Based on the control signal CS generated by the clock controller 106d, timing or synchronization operation of the first functional circuit 102a may be controlled. Thus, a controlled synchronization operation may be initiated to prevent the timing errors or the synchronization errors in the first functional circuit 102a. Although it is mentioned that the controlled synchronization operation may be initiated to prevent the timing errors or the synchronization errors in the first functional circuit 102a, in various embodiments, the clock controller 106d may be coupled to the reset controller 106a such that the control signal CS may further initiate a reset operation in the first functional circuit 102.

The set of controllers 106 may be further configured to provide the control signal CS to the request regulator 104. Upon receiving the control signal CS, the request regulator 104 may be further configured to generate the response denoted by "RS" in FIG. 1, to initiate the control operation associated with the at least one functional circuit that generates the highest graded request HGRQ. The functional circuit of may be configured to receive the response RS from the request regulator 104. Upon receiving the response RS, a corresponding control operation associated with the functional circuit may be initiated. For example, the request regulator 104 may provide the response RS to the first functional circuit 102a when the first request RQ1 may have the highest grade (e.g., the highest graded request HGRQ). Further, the first functional circuit 102a may be configured to receive the response RS from the request regulator 104. Upon receiving the response RS, the first functional circuit 102a may be further configured to initiate the corresponding control operation. In an example, the response RS may initiate the reset operation (such as a destructive reset) of the first functional circuit 102a.

Although in the above example, it is mentioned that the first functional circuit 102a may receive the response RS from the request regulator 104, in various scenarios, the second functional circuit 102b may receive the response RS (shown by dotted line in FIG. 1) from the request regulator 104 when the second request RQ2 may have the highest grade (e.g., the second request RQ2 may be the highest graded request HGRQ). In such a scenario, the first functional circuit 102a may receive the disable signal DS (shown by dotted line in FIG. 1) and the third functional circuit 102c and the fourth functional circuit 102d may receive the disable signal DS. In further scenarios, the third functional circuit 102c and the fourth functional circuit 102d may receive the response RS (shown by dotted line in FIG. 1) from the request regulator 104 when the third request RQ3 may have the highest grade (e.g., the third request RQ3 may be the highest graded request HGRQ). In such scenarios, the first functional circuit 102a may receive the disable signal DS (shown by dotted line in FIG. 1) and the second functional circuit 102b may receive the disable signal DS. Thus, each of the plurality of functional circuits 102 may be dynamically configured to receive the response RS based on the corresponding context information.

In further embodiments, the request regulator 104 may provide the response RS to each of the plurality of functional circuits 102 when the highest graded request HGRQ may correspond to a power-on reset (POR) event. Upon receiving the response RS, each of the plurality of functional circuits 102 may initiate the reset operation.

Although it is mentioned that the set of controllers 106 may include the reset controller 106a, the fault controller 106b, the security controller 106c, and the clock controller 106d, in various embodiments, the set of controllers 106 may include a plurality of controllers such as a memory controller, an interrupt controller, a power management controller, a safety controller, or the like.

Although it is mentioned that a control operation is executed, in various embodiments, two or more control operations associated with the functional circuit that may generate the highest graded request HGRQ may be executed.

It will be understood by a person skilled in the art that more than one event may simultaneously occur in any of the plurality of functional circuits 102a-102d. Each request may thus be generated based on the occurrence of more than one event. In such a scenario, more than one control operation may be executed on any of the plurality of functional circuits 102a-102d that generates the highest graded request HGRQ.

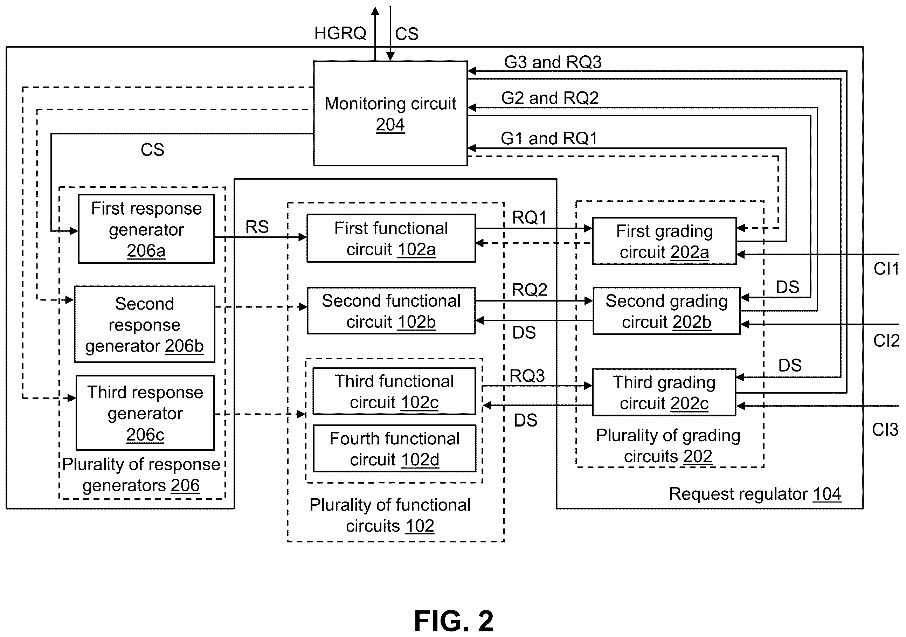

FIG. 2 illustrates a schematic diagram of the request regulator 104 and the plurality of functional circuits 102, in accordance with an embodiment of the present disclosure. The request regulator 104 may include a plurality of grading circuits 202, a monitoring circuit 204, and a plurality of response generators 206.

### Plurality of grading circuits 202:

The plurality of grading circuits 202 may be coupled to the plurality of functional circuits 102. Additionally, the plurality of grading circuits 202 may be further coupled to the processor. The plurality of grading circuits 202 may include suitable circuitry that may be configured to perform one or more operations. For example, each grading circuit of the plurality of grading circuits 202 may be configured to receive the plurality of requests RQ1-RQ3 generated by the plurality of functional circuits 102 and grade each request of the plurality of requests RQ1-RQ3 based on the associated context information as explained in the ongoing disclosure.

The plurality of grading circuits 202 may include a first grading circuit 202a, a second grading circuit 202b, and a third grading circuit 202c. Each functional circuit of the plurality of functional circuits 102 may be coupled to a corresponding grading circuit of the plurality of grading circuits 202. Thus, the first grading circuit 202a may be coupled to the first functional circuit 102a and the processor. The second grading circuit 202b may be coupled to the second functional circuit 102b and the processor. Further, the third grading circuit 202c may be coupled to the third functional circuit 102c, the fourth functional circuit 102d, and the processor. Examples of the plurality of grading circuits 202 may correspond to a microcontroller, an application-specific integrated circuit (ASIC), or the like.

The first grading circuit 202a may be configured to receive the first request RQ1 from the first functional circuit 102a. The first grading circuit 202a may be further configured to receive the first context information CI1 associated with the first functional circuit 102a from the processor. Based on the first context information CI1, the first grading circuit 202a may be further configured to grade the first request RQ1. The grading of the first request RQ1 may correspond to determining a grade of the first request RQ1. Further, the first grading circuit 202a may be configured to generate first grading information (e.g., the determined grade) denoted by "G1" in FIG. 2. The first grading information G1 and the first request RQ1 are provided to the monitoring circuit 204.

In a scenario, based on execution of the first application, the first context information C1 may indicate a highest priority level for the first functional circuit 102a. Thus, the predefined grade (e.g., the highest grade) may be determined for the first request RQ1 based on the first context information CI1. Thus, the first grading information G1 may have the highest grade. In another scenario, upon executing the second application, the first context information C1 may indicate a low priority level for the first functional circuit 102a. Thus, a lowest grade may be determined for the first request RQ1 based on the first context information CI1. Thus, the first grading information G1 may have the lowest grade. In further scenarios, upon re-executing the first application, the first context information C1 may indicate an intermediate priority level for the first functional circuit 102a. Thus, an intermediate grade may be determined for the first request RQ1 based on the first context information CI1. Thus, the first grading information G1 may have the intermediate grade. The first grading circuit 202a may thus, dynamically grade the first request RQ1 with at least one of the highest grade, the intermediate grade, or the lowest grade based on the execution of a corresponding application. For the sake of brevity of explaining FIG. 2, it is assumed that the highest grade may be determined for the first request RQ1.

In an embodiment, the first request RQ1 may correspond to 2 bits of data that may be generated by the first functional circuit 102a. Further, the first grading information G1 may correspond to additional 2 bits of data that may be generated by the first grading circuit 202a based on the first context information CI1.

The second grading circuit 202b may be configured to receive the second request RQ2 from the second functional circuit 102b. The second grading circuit 202b may be further configured to receive the second context information CI2 associated with the second functional circuit 102b from the processor. Based on the second context information CI2, the second grading circuit 202b may be further configured to grade the second request RQ2 (e.g., determine a grade of the second request RQ2) and generate second grading information denoted by "G2" in FIG. 2. Further, the second grading circuit 202b may be configured to provide the second grading information G2 and the second request RQ2 to the monitoring circuit 204.

The third grading circuit 202c may be configured to receive the third request RQ3 from at least one of the third functional circuit 102c and the fourth functional circuit 102d. The second grading circuit 202b may be further configured to receive third context information CI3 associated with the third functional circuit 102c and the fourth functional circuit 102d from the processor. Based on the third context information CI3, the third grading circuit 202c may be further configured to grade the third request RQ3 (e.g., determine a grade for the third request RQ3). Further, the third grading circuit 202c may be configured to generate and provide third grading information denoted by "G3" in FIG. 2 to the monitoring circuit 204and further provide the third request RQ3 to the monitoring circuit 204. Similar to the dynamic grading of the first request RQ1 that is based on the execution of a corresponding application, each of the second grading circuit 202b and the third grading circuit 202c may dynamically grade the second request RQ2 and the third request RQ3, respectively, with a highest, lowest, or intermediate grade based on the execution of a set of applications.

In a scenario, the second grading circuit 202b may be configured to receive the disable signal DS from the monitoring circuit 204 and provide the disable signal DS to the second functional circuit 102b. Further, the third grading circuit 202c may be configured to receive the disable signal DS from the monitoring circuit 204 and provide the disable signal DS to the third functional circuit 102c and the fourth functional circuit 102d. In further scenarios, the first grading circuit 202a may receive the disable signal DS from the monitoring circuit 204 (as shown by the dotted line in FIG. 2).

In various embodiments, each of the plurality of grading circuits 202 may be configured to provide a single graded request, to the monitoring circuit 204 such that the graded request includes the associated grading information.

### Monitoring circuit 204:

The monitoring circuit 204 may be coupled to the plurality of grading circuits 202 (*e.g.,* the first grading circuit 202a, the second grading circuit 202b, and the third grading circuit 202c) and the set of controllers 106 (*e.g.,* the reset controller 106a, the fault controller 106b, the security controller 106c, and the clock controller 106d). The monitoring circuit 204 may include suitable circuitry that may be configured to perform one or more operations. For example, the monitoring circuit 204 may be configured to receive each of the plurality of requests RQ1-RQ3 that may be graded. In other words, the monitoring circuit 204 may be configured to receive the first request RQ1 with the first grading information G1, the second request RQ2 with the second grading information G2, and the third request RQ3 with the third grading information G3 from the first grading circuit 202a, the second grading circuit 202b, and the third grading circuit 202c, respectively. Examples of the monitoring circuit 204 may correspond to a state machine execution circuit, an application-specific integrated circuit (ASIC), or the like.

The monitoring circuit 204 may be further configured to identify the highest grade based on the first grading information G1, the second grading information G2, and the third grading information G3. Upon identifying the highest grade, the monitoring circuit 204 may be further configured to select the set of requests from the plurality of requests RQ1-RQ3 such that the selected set of requests may have the highest grade (e.g., the highest graded request HGRQ) than the remaining requests. Further, the monitoring circuit 204 may be further to configured to block the remaining requests. In an example, the monitoring circuit 204 may select the first request RQ1 as the highest graded request HGRQ. The first request RQ1 may be selected based on the first grading information G1 indicating the highest grade. The monitoring circuit 204 may be further to configured to block the remaining requests (e.g., the second request RQ2 and the third request RQ3).

Upon blocking the remaining requests, the monitoring circuit 204 may be further configured to disable the corresponding functional circuits of the plurality of functional circuits 102 for the time period by generating the disable signal DS. Further, the monitoring circuit 204 may be configured to provide the disable signal DS to grading circuits of the plurality of grading circuits 202 that may provide the remaining requests. The grading circuits may be further configured to provide the disable signal DS to corresponding functional circuits of the plurality of grading circuits 202 that may generate the remaining requests. Upon receiving the disable signal DS, the corresponding functional circuits may be disabled for the time period. In a scenario, the monitoring circuit 204 may provide the disable signal DS to the second grading circuit 202b and the third grading circuit 202c. Further, the second grading circuit 202b may be further configured to provide the disable signal DS to the second functional circuit 102b. Additionally, the third grading circuit 202c may be further configured to provide the disable signal DS to each of the third functional circuit 102c and the fourth functional circuit 102d. The second functional circuit 102b, the third functional circuit 102c, and the fourth functional circuit 102d may be disabled for the time period upon receiving the disable signal DS. The disable signal DS may thus disable the generation of the second request RQ2 and the third request RQ3 for the time period. In addition, the disable signal DS may isolate the second functional circuit 102b, the third functional circuit 102c, and the fourth functional circuit 102d from receiving any sensor data or executing the normal operations thereby disabling further sampling of the sensor data for the time period.

The monitoring circuit 204 may be further configured to determine the control operation to be initiated based on the highest graded request HGRQ (e.g., the selected set of requests). The monitoring circuit 204 may be further configured to provide the highest graded request HGRQ (e.g., the set of requests) to at least one controller of the set of controllers 106 based on determination of the control operation to be initiated. In an embodiment, the highest graded request HGRQ may comprise an identifier associated with the reset controller 106a such that the monitoring circuit 204 may provide the first request RQ1 to the reset controller 106a. Further, the reset controller 106a may generate the control signal CS based on the highest graded request HGRQ. The monitoring circuit 204 may be further configured to receive the control signal CS from the reset controller 106a.

The monitoring circuit 204 may be further configured to identify, based on the highest graded request HGRQ, at least one response generator of the plurality of response generators 206 to receive the control signal CS. Further, upon identifying the response generator, the monitoring circuit 204 may be configured to provide the control signal CS to the identified response generator. In a scenario, the monitoring circuit 204 may identify the first response generator 206a to receive the control signal CS. The monitoring circuit 204 may be further configured to store the diagnostics data associated with the control operation that may be initiated based on the highest graded request HGRQ. In further scenarios, the monitoring circuit 204 may identify the second response generator 206b to receive the control signal CS (as shown by dotted line in FIG. 1) or the third response generator 206c to receive the control signal CS (as shown by dotted line in FIG. 1) as compared to the first response generator 206a.

In various embodiments, the monitoring circuit 204 may include a multiplexer and a priority identification circuit. The priority identification circuit may receive the first through third grading information G1-G3. The multiplexer may receive the plurality of requests RQ1-RQ3 as input signals to the multiplexer. The priority identification circuit may identify the highest graded information amongst the first through third grading information G1-G3, and the identified highest graded information may be provided as a select signal to the multiplexer by the priority identification circuit. Further, the set of requests may be selected based on the select signal to the multiplexer.

### Plurality of response generators 206:

The plurality of response generators 206 may be coupled to the monitoring circuit 204. The plurality of response generators 206 may include a first response generator 206a, a second response generator 206b, and a third response generator 206c. Each response generator of the plurality of response generators 206 may be coupled to a corresponding set of functional circuits of the plurality of functional circuits 102. For example, the first response generator 206a may be coupled to the first functional circuit 102a and the monitoring circuit 204. The second response generator 206b may be coupled to the second functional circuit 102b and the monitoring circuit 204. Further, the third response generator 206c may be coupled to the third functional circuit 102c, the fourth functional circuit 102d, and the monitoring circuit 204. Examples of the plurality of response generators 206 may correspond to a field programmable gate array (FPGA), a programmable logic device, or the like.

In a scenario, the monitoring circuit 204 may identify the first response generator 206a to receive the control signal CS based on the coupling of the first response generator 206a to the first functional circuit 102a. The monitoring circuit 204 may thus provide the control signal CS to the first response generator 206a. The first response generator 206a may be configured to receive the control signal CS from the monitoring circuit 204. Further, the first response generator 206a may be configured to generate the response RS based on the control signal CS to initiate the control operation associated with the first functional circuit 102a. In an example, when the control signal CS may indicate the reset operation, the response RS may be generated to reset the first functional circuit 102a. The first response generator 206a may be further configured to provide the response RS to the first functional circuit 102a. The first functional circuit 102a may receive the response RS from the first response generator 206a. Upon receiving the response RS, the first functional circuit 102a may initiate the corresponding control operation (e.g., a destructive reset associated with the reset operation).

In various scenarios, the monitoring circuit 204 may identify the second response generator 206b to receive the control signal CS (shown by dotted line in FIG. 2). In such a scenario, the second response generator 206b may generate and provide the response RS to the second functional circuit 102b (shown by dotted line in FIG. 2). In further scenarios, the monitoring circuit 204 may identify the third response generator 206c to receive the control signal CS (shown by dotted line in FIG. 2). In such scenarios, the third response generator 206c may generate and provide the response RS to the third functional circuit 102c and the fourth functional circuit 102d (shown by dotted line in FIG. 2).

Although it is mentioned that the monitoring circuit 204 may identify the first response generator 206a to receive the control signal CS, in various scenarios, the monitoring circuit 204 may identify more than one response generator of the plurality of response generators 206. For example, when the first request RQ1 may further correspond to the POR reset event such that each functional circuit of the plurality of functional circuits 102 may reset, the monitoring circuit 204 may provide the control signal CS to each response generator of the plurality of response generators 206. Further, each response generator of the plurality of response generators 206 may be configured to generate the response RS based on the control signal CS. Each response generator may be further configured to provide the response RS to functional circuits coupled to the corresponding response generator.

In further embodiments, the plurality of response generators 206 may correspond to a plurality of multiplexers. Each multiplexer may be coupled to a functional circuit of the plurality of functional circuits 102. The monitoring circuit 204 may identify a first multiplexer of the plurality of multiplexers to receive the control signal CS as a select signal based on coupling of the first multiplexer with the first functional circuit 102a. Further, inputs to the first multiplexer may be various control events such as the functional reset, the destructive reset, the POR reset, or the like, that may be received from the set of controllers 106. Based on the control signal CS, the first multiplexer may output the response RS such that the response RS may correspond to a control operation (e.g., one of the functional reset, the destructive reset, the POR reset) for the first functional circuit 102a.

Although it is shown that the plurality of grading circuits 202 include multiple grading circuits, in various embodiments, the plurality of grading circuits 202 may be replaced with a single grading circuit that may be coupled to each functional circuit of the plurality of functional circuits 102. The grading circuit may further receive context information associated with each functional circuit of the plurality of functional circuits 102. The grading circuit may dynamically grade each request upon comparing the priority level associated with each context information to generate the first through third grading information G1-G3.

Although it is shown that the plurality of response generators 206 include multiple response generators, in various embodiments, the plurality of response generators 206 may be replaced with a single response generator that may be coupled to each functional circuit of the plurality of functional circuits 102. The response generator may receive the control signal CS from the monitoring circuit 204. The response generator may identify the control operation indicated by the control signal CS. Based on the identified control operation, the response generator may generate the response RS. The response generator may further receive the context information indicating the highest priority level from the plurality of grading circuits 202 or the processor. The response generator may further provide the response RS to one or more functional circuits of the plurality of functional circuits 102 based on the associated context information indicating the highest priority level.

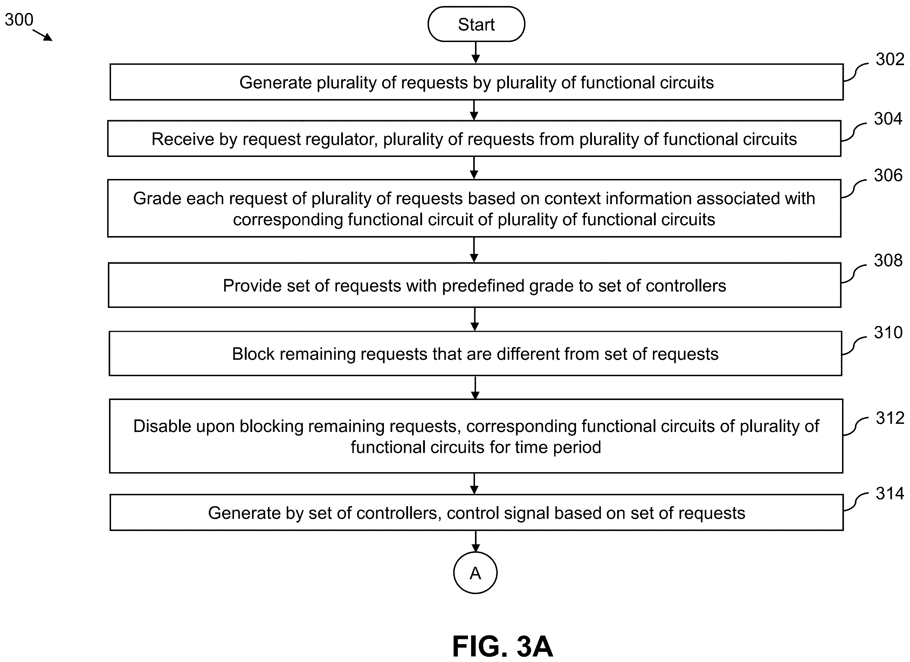

FIGS. 3A-3B, collectively, represent a flowchart 300 that illustrates a method executed by the system 100, in accordance with an embodiment of the present disclosure. The plurality of functional circuits 102 may detect the abnormal event in the corresponding functional circuit. For the sake of brevity of explaining the ongoing description, it is assumed that the abnormal event occurs in each functional circuit of the plurality of functional circuits 102.

Referring now to FIG. 3A, at step 302, the plurality of functional circuits 102 may generate the plurality of requests RQ1-RQ3 based on the occurrence of the one or more events. The plurality of functional circuits 102 may provide the plurality of requests RQ1-RQ3 to the request regulator 104. At step 304, the request regulator 104 may receive the plurality of requests RQ1-RQ3 from the plurality of functional circuits 102. At step 306, the request regulator 104 may grade each request of the plurality of requests RQ1-RQ3 based on the context information associated with the corresponding functional circuit of the plurality of functional circuits 102. At step 308, the request regulator 104 may provide the set of requests of the plurality of requests RQ1-RQ3 with the predefined grade (e.g., the highest graded request HGRQ) to the set of controllers 106. At step 310, the request regulator 104 may block the remaining requests from the plurality of requests RQ1-RQ3 that are different from the set of requests (e.g., the highest graded request HGRQ). At step 312, upon blocking the remaining requests, the request regulator 104 may disable the corresponding functional circuits of the plurality of functional circuits 102 for the time period. The time period may correspond to the time interval to execute the control operation associated with the set of requests. At step 314, the set of controllers 106 may generate the control signal CS based on the set of requests.

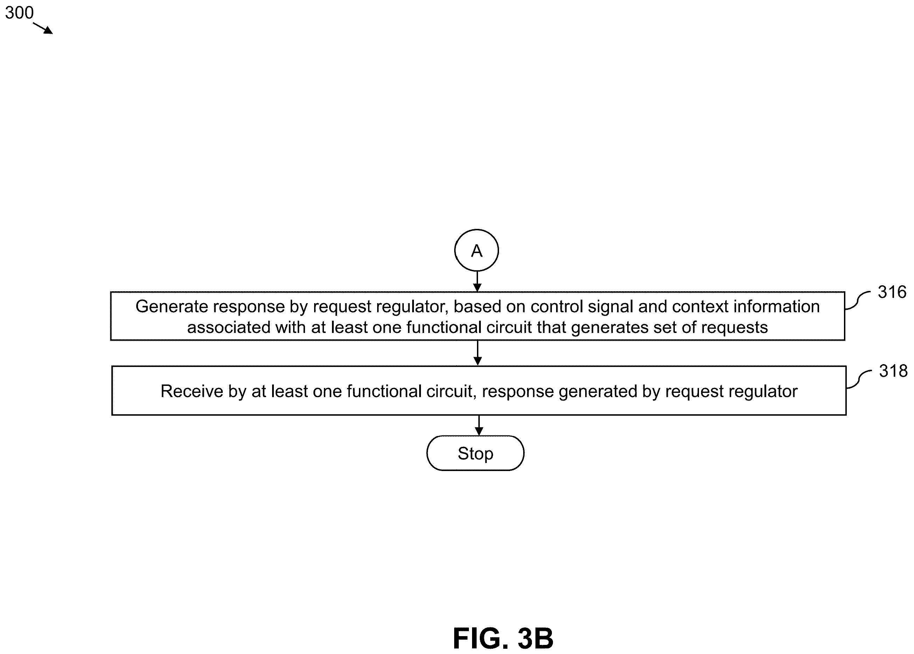

Referring now to FIG. 3B, at step 316, the request regulator 104 may generate the response RS based on the control signal CS and the context information associated with at least one functional circuit of the plurality of functional circuits 102 that may generate the set of requests. The response RS may be generated to initiate the control operation associated with the functional circuit. At step 318, the at least one functional circuit may receive the response RS generated by the request regulator 104.

The request regulator 104 may offer a scalable solution to manage complex interactions between a large number of functional circuits (e.g., the plurality of functional circuit 102) and controllers (e.g., the set of controllers 106). The request regulator 104 of the present disclosure may dynamically grade the plurality of requests RQ1-RQ3 generated by the plurality of functional circuits 102 based on the context information associated with the plurality of functional circuits 102. The context information may be configurable based on execution of at least one application by the processor and may vary based on a virtualized environment where the application is executed. Further, by selectively providing one or more predefined graded requests (e.g., the highest graded request HGRQ) to the set of controllers 106, the request regulator 104 may eliminate complications due to cross domain interactions (e.g., reset domain crossing, clock domain crossing, or the like).

The request regulator 104 may block requests other than the highest graded request HGRQ to avoid generation of erroneous requests due to cross-talk between the plurality of functional circuits 102 and the set of controllers 106. In the absence of erroneous requests, the request regulator 104 may timely generate the response RS, thereby initiating the control operation to rectify errors or faults in the corresponding functional circuits. Thus, the recovery associated with the functional circuits corresponds to lowest granular recovery (e.g., recovery without escalations or generation of erroneous requests). As the functional circuits may be timely recovered, the functional circuits may be available to execute operations associated with the SoC that includes the system 100. Additionally, in absence of the cross-domain interactions, errata corresponding to the SoC of the present disclosure is optimized, thereby improving reliability of the SoC to the users and enhancing an operational reliability of the SoC. The plurality of requests RQ-RQ3 are processed without the need to implement complex masking architectures. Thus, the system 100 is simple to design. Further, the SoC that implements the system 100 has a reduced size over conventional SoCs that implement complex masking architectures.

In an embodiment, a system may be disclosed. The system may comprise a plurality of functional circuits configured to generate a plurality of requests based on occurrence of one or more events. The system may further comprise a request regulator coupled to the plurality of functional circuits. The request regulator may be configured to receive the plurality of requests, and grade based on context information associated with each functional circuit of the plurality of functional circuits, each request of the plurality of requests such that a set of requests of the plurality of requests has a predefined grade. The request regulator may be further configured to generate, based on the set of requests, a response to initiate a control operation associated with at least one functional circuit of the plurality of functional circuits.

In some embodiments, the request regulator may be further configured to block remaining requests from the plurality of requests that may be different from the set of requests.

In some embodiments, upon blocking the remaining requests, the request regulator may be further configured to disable for a time period, corresponding functional circuits of the plurality of functional circuits.

In some embodiments, the request regulator may further comprise a plurality of grading circuits, wherein each functional circuit of the plurality of functional circuits may be coupled to a corresponding grading circuit of the plurality of grading circuits.

In some embodiments, each grading circuit of the plurality of grading circuits may be configured to receive a request of the plurality of requests and the context information associated with each functional circuit of the plurality of functional circuits and grade the received request based on the associated context information.

In some embodiments, the request regulator may further comprise a monitoring circuit coupled to the plurality of grading circuits, wherein the monitoring circuit may be configured to receive each request of the plurality of requests that may be graded and select the set of requests, wherein the set of requests having the predefined grade may indicate that the set of requests has a highest grade, and wherein based on the selected set of requests, the request regulator may generate the response.

In some embodiments, the system may further comprise a set of controllers coupled to the request regulator, wherein the request regulator may be further configured to provide the set of requests to the set of controllers, and wherein the set of controllers may be further configured to generate a control signal based on the set of requests.

In some embodiments, the set of controllers may be further configured to provide the control signal to the request regulator, wherein the request regulator may generate the response based on the control signal.

In some embodiments, the at least one functional circuit of the plurality of functional circuits may be further configured to receive the response from the request regulator, wherein upon receiving the response, the control operation associated with the at least one functional circuit may be initiated.

In some embodiments, the control operation may correspond to at least one of a reset operation, a fault control operation, a security operation, and a synchronization operation.

In some embodiments, the request regulator may dynamically grade each request of the plurality of requests based on execution of a set of applications, wherein the context information may vary based on the execution of each application of the set of applications.

In some embodiments, when the control operation may correspond to a reset operation, the at least one functional circuit may be further configured to receive the response from the request regulator and initiate the reset operation.

In some embodiments, (i) a functional circuit of the plurality of functional circuits may generate a request of the plurality of requests and (ii) at least two or more functional circuits of the plurality of functional circuits are grouped to generate another request of the plurality of requests.

In some embodiments, the at least one functional circuit may generate the set of requests, wherein based on the context information indicating a highest level of priority for the at least one functional circuit, the request regulator may grade the set of requests with the predefined grade.

In some embodiments, the request regulator may comprise a plurality of response generators, wherein each response generator of the plurality of response generators may be coupled to each functional circuit of the plurality of functional circuits.

In some embodiments, the request regulator may further comprise a monitoring circuit coupled to the plurality of response generators, wherein the monitoring circuit may be further configured to identify, based on the set of requests, at least one response generator of the plurality of response generators to receive a control signal, and wherein the control signal may be generated based on the set of requests.

In some embodiments, the at least one response generator may be configured to receive the control signal, generate the response based on the control signal. and provide the response to the at least one functional circuit coupled to the at least one response generator.

In some embodiments, the control signal may be associated with one of a functional reset, a destructive reset, a power-on-reset, and the at least one response generator may provide the response based on one of the functional reset, the destructive reset, and the power-on-reset to the at least one functional circuit.

In further embodiments, a method may be disclosed. The method may comprise generating, by a plurality of functional circuits, a plurality of requests based on occurrence of one or more events, and receiving, by a request regulator, the plurality of requests. The method may comprise grading, by the request regulator, each request of the plurality of requests based on context information associated with each functional circuit of the plurality of functional circuits such that a set of requests of the plurality of requests has a predefined grade. The method may comprise generating, by the request regulator, a response to initiate a control operation associated with at least one functional circuit of the plurality of functional circuits based on the set of requests.

In some embodiments, the method may further comprise blocking, by the request regulator, remaining requests from the plurality of requests that may be different from the set of requests, and disabling for a time period, by the request regulator, corresponding functional circuits of the plurality of functional circuits.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the s scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements. The term "coupled" may refer to at least one of direct or indirect coupling that may not necessarily be by way of mechanical or any physical means. Further, a system or method that "comprises", "has", or "includes" one or more elements possesses those one or more elements but is not limited to possessing only those one or more elements.

## Claims

1. A system comprising:
a plurality of functional circuits configured to generate a plurality of requests based on occurrence of one or more events; and
a request regulator coupled to the plurality of functional circuits, wherein the request regulator is configured to:
receive the plurality of requests;
grade, based on context information associated with each functional circuit of the plurality of functional circuits, each request of the plurality of requests such that a set of requests of the plurality of requests has a predefined grade; and
generate, based on the set of requests, a response to initiate a control operation associated with at least one functional circuit of the plurality of functional circuits.

2. The system of claim 1, wherein the request regulator is further configured to block remaining requests from the plurality of requests that are different from the set of requests.

3. The system of claim 2, wherein upon blocking the remaining requests, the request regulator is further configured to disable for a time period, corresponding functional circuits of the plurality of functional circuits.

4. The system of any preceding claim, wherein the request regulator comprises a plurality of grading circuits, wherein each functional circuit of the plurality of functional circuits is coupled to a corresponding grading circuit of the plurality of grading circuits.

5. The system of claim 4, wherein each grading circuit of the plurality of grading circuits is configured to:
receive a request of the plurality of requests and the context information associated with each functional circuit of the plurality of functional circuits; and
grade the received request based on the associated context information.

6. The system of claim 4 or 5, wherein the request regulator further comprises a monitoring circuit coupled to the plurality of grading circuits, wherein the monitoring circuit is configured to:
receive each request of the plurality of requests that is graded; and
select the set of requests, wherein the set of requests having the predefined grade indicates that the set of requests has a highest grade, and wherein based on the selected set of requests, the request regulator generates the response.

7. The system of any preceding claim, further comprising a set of controllers coupled to the request regulator,
wherein the request regulator is further configured to provide the set of requests to the set of controllers, and
wherein the set of controllers is further configured to generate a control signal based on the set of requests.

8. The system of claim 7,
wherein the set of controllers is further configured to provide the control signal to the request regulator, and
wherein the request regulator generates the response based on the control signal.

9. The system of any preceding claim, wherein the at least one functional circuit of the plurality of functional circuits is further configured to receive the response from the request regulator, wherein upon receiving the response, the control operation associated with the at least one functional circuit is initiated.

10. The system of any preceding claim, wherein the control operation corresponds to at least one of a reset operation, a fault control operation, a security operation, and a synchronization operation.

11. The system of claim 1, wherein the request regulator grades each request of the plurality of requests dynamically based on execution of a set of applications, and wherein the context information varies based on the execution of each application of the set of applications.

12. The system of any preceding claim, wherein when the control operation corresponds to a reset operation, the at least one functional circuit is further configured to:
receive the response from the request regulator; and
initiate the reset operation.

13. The system of any preceding claim, wherein (i) a functional circuit of the plurality of functional circuits generates a request of the plurality of requests and (ii) at least two or more functional circuits of the plurality of functional circuits are grouped to generate another request of the plurality of requests.

14. The system of any preceding claim, wherein the at least one functional circuit generates the set of requests, and wherein based on the context information indicating a highest level of priority for the at least one functional circuit, the request regulator grades the set of requests with the predefined grade.

15. A method comprising:
generating, by a plurality of functional circuits, a plurality of requests based on occurrence of one or more events;
receiving, by a request regulator, the plurality of requests;
grading, by the request regulator, each request of the plurality of requests based on context information associated with each functional circuit of the plurality of functional circuits such that a set of requests of the plurality of requests has a predefined grade; and
generating, by the request regulator, a response to initiate a control operation associated with at least one functional circuit of the plurality of functional circuits based on the set of requests.
